# EUROPEAN PATENT APPLICATION

(11) **EP 4 760 867 A1**
(43) Date of publication of application: **17.06.2026**
(21) Application number: 25782904.4
(22) Date of filing: 31.03.2025
(51) Int. Cl.: H01M 10/48, H01M 10/04, G01R 31/378, H01M 10/42

(54) **APPARATUS AND METHOD FOR EVALUATING ELECTROLYTE IMPREGNATION LEVEL OF SECONDARY BATTERY**

(30) Priority: 02.04.2024 KR 20240044943
(71) Applicant: LG Energy Solution, Ltd., Seoul 07335 (KR)
(72) Inventor: KWON, Hyun-Cheol, Daejeon 34122 (KR); KIM, Hak-Kyun, Daejeon 34122 (KR); PARK, Ji-Won, Daejeon 34122 (KR)
(74) Representative: Goddar, Heinz J.
(86) International application number: PCT/KR2025/004182
(87) International publication number: WO 2025/211682

(57) **Abstract**

Disclosed is an apparatus and method of evaluating an electrolyte impregnation level of a secondary battery. Specifically, electrolyte is injected into a case of the 3-electrode cell, and the 3-electrode cell is aged for a first time. Charging of the 3-electrode cell is initiated, and a first SOC voltage between the reference terminal and the positive electrode terminal at the first SOC is obtained. The 3-electrode cell is aged for 2 hours, and then an aging completion voltage between the reference terminal and the positive electrode terminal is obtained. Charging of the 3-electrode cell is resumed, and a second SOC voltage between the reference terminal and the positive electrode terminal at a second SOC is obtained. At least one of the first SOC voltage, a voltage difference between the first SOC voltage and the aging completion voltage, and a voltage difference between the first SOC voltage and the second SOC voltage is determined as an impregnation evaluation voltage. An electrolyte impregnation level corresponding to the impregnation evaluation voltage is identified from reference voltage information for a plurality of predefined electrolyte impregnation levels, and the identified electrolyte impregnation level is determined as an electrolyte impregnation level of the 3-electrode cell.

## Description

### TECHNICAL FIELD

The present disclosure relates to an apparatus and method of evaluating an electrolyte impregnation level of a secondary battery, and more particularly, to an apparatus and method for quantitatively evaluating an electrolyte impregnation level of a secondary battery from a voltage difference between a reference electrode and a positive electrode using a 3-electrode cell including a reference electrode.

This application is based on and claims priority from Korean Patent Application No. 10-2024-0044943, filed on April 2, 2024, with the Korean Intellectual Property Office, the disclosure of which is incorporated herein in its entirety by reference.

### BACKGROUND ART

Recently, with the increase in technological development and demand for mobile devices, small aircrafts, electric vehicles, power storage systems and so on, the demand for secondary batteries such as lithium secondary batteries is rapidly increasing.

The secondary battery includes an electrode assembly having a separator interposed between a positive electrode and a negative electrode, where an active material is applied on an electrode current collector. The electrode assembly is impregnated with an electrolyte that transfers operating ions between the positive electrode and the negative electrode during charging and discharging of the secondary battery.

The electrode assembly includes one or more unit cells with a separator interposed between a positive electrode and a negative electrode. The electrode assembly has various structures, such as a simple stacked type, a jelly-roll type, and a stacked/folded type, depending on whether the one or more unit cells are stacked and/or wound.

The electrode assembly is inserted into a case made of a metal can, a flexible pouch package, etc. of a certain size and shape. After that, the secondary battery is completely assembled by injecting electrolyte into the case and sealing the case.

The electrolyte injected into the case permeates between the positive electrode, the negative electrode, and the separator by capillary force. The electrolyte impregnates the separator and the electrodes until the assembled secondary battery is put into the formation process. The performance of the secondary battery is determined by the impregnation level of the electrolyte before the formation process. In particular, if the separator or the electrode is not sufficiently impregnated with the electrolyte, the efficiency of the secondary battery deteriorates and its lifespan is shortened. Therefore, a technology to quantitatively evaluate the impregnation level of the electrolyte during the development or production process of the secondary battery is required.

In the conventional electrolyte impregnation evaluation method, electrolyte is injected into the case containing the electrode assembly to impregnate the electrode assembly with the electrolyte, and the electrode assembly is aged for a predetermined period of time. Then, the electrode assembly is disassembled and the electrode surface is visually observed to qualitatively evaluate the impregnation level of the electrolyte. For example, as the area on the electrode surface where no traces of electrolyte impregnation is visible is more, the electrolyte impregnation level is evaluated to be lower.

However, the method of directly checking the electrolyte non-impregnation area of the electrode after disassembling the electrode assembly has limitations in that it is difficult to quantitatively evaluate the impregnation level of the electrode assembly and is difficult to apply to an automated secondary battery production process.

Therefore, in the technical field to which the present disclosure belongs, a method that may quantitatively and accurately evaluate the electrolyte impregnation level without disassembling the electrode assembly is required.

### DISCLOSURE

### Technical Problem

The present disclosure is designed to solve the problems of the related art, and therefore the present disclosure is directed to providing an apparatus and method of evaluating an electrolyte impregnation level of a secondary battery, which may quantitatively evaluate the impregnation level of electrolyte without disassembling the electrode assembly.

In addition, by providing a system including the apparatus of evaluating an electrolyte impregnation level of a secondary battery and a computer that manages a production line of the secondary battery, the present disclosure is also directed to managing the electrolyte impregnation level at an optimal level by adaptively controlling the process condition of the injecting process using the electrolyte impregnation level evaluated for a 3-electrode cell manufactured from a semi-finished cell sampled from the production line of the secondary battery.

### Technical Solution

In one aspect of the present disclosure, there is provided a method of evaluating an electrolyte impregnation level of a secondary battery, comprising: (a) preparing a 3-electrode cell including a positive electrode terminal, a negative electrode terminal, and a reference terminal; (b) injecting electrolyte into a case of the 3-electrode cell and aging the 3-electrode cell for a first time; (c) charging the 3-electrode cell to a preset first SOC (State Of Charge) and obtaining a first SOC voltage between the reference terminal and the positive electrode terminal at the first SOC; (d) aging the 3-electrode cell in a no-load state for a second time and then obtaining an aging completion voltage between the reference terminal and the positive electrode terminal; (e) obtaining a second SOC voltage between the reference terminal and the positive electrode terminal at a second SOC while charging the 3-electrode cell from the first SOC to the second SOC; (f) determining at least one of the first SOC voltage, a voltage difference between the first SOC voltage and the aging completion voltage, and a voltage difference between the first SOC voltage and the second SOC voltage as an impregnation evaluation voltage; and (g) identifying an electrolyte impregnation level corresponding to the impregnation evaluation voltage from reference voltage information for a plurality of predefined electrolyte impregnation levels and determining the identified electrolyte impregnation level as an electrolyte impregnation level of the 3-electrode cell.

The reference voltage information may include first to n^{th} electrolyte impregnation levels (n is a natural number greater than or equal to 2) and first to n^{th} voltage section information respectively corresponding to the electrolyte impregnation levels.

In the reference voltage information, the first to n^{th} voltage section information may be set differently depending on a type of the impregnation evaluation voltage.

In the (f) step, the first SOC voltage, the voltage difference between the first SOC voltage and the aging completion voltage, and the voltage difference between the first SOC voltage and the second SOC voltage may be determined as a first impregnation evaluation voltage, a second impregnation evaluation voltage, and a third impregnation evaluation voltage, respectively.

In the (g) step, a first electrolyte impregnation level, a second electrolyte impregnation level, and a third electrolyte impregnation level respectively corresponding to the first impregnation evaluation voltage, the second impregnation evaluation voltage, and the third impregnation evaluation information may be determined from the reference voltage information for the plurality of predefined electrolyte impregnation levels, and an average of the first electrolyte impregnation level, the second electrolyte impregnation level, and the third electrolyte impregnation level may be determined as the electrolyte impregnation level of the 3-electrode cell.

The first time may 0 to 48 hours, preferably 24 hours, and the second time may be 12 to 48 hours, preferably 24 hours.

The first SOC may be 3% to 7%, preferably 5%, and the second SOC may be 8% to 12%, preferably 10%.

The (c) step may include (c1) generating a first voltage profile by repeatedly measuring a voltage difference between the reference terminal and the positive electrode terminal at time intervals while charging the 3-electrode cell to a preset first SOC; and (c2) obtaining an end voltage of the first voltage profile as the first SOC voltage.

The (d) step may include (d1) generating a second voltage profile by repeatedly measuring a voltage difference between the reference terminal and the positive electrode terminal at time intervals while aging the 3-electrode cell in a no-load state for a second time; and (d2) obtaining an end voltage of the second voltage profile as the aging completion voltage.

The (e) step may include (e1) obtaining a third voltage profile by repeatedly measuring a voltage difference between the reference terminal and the positive electrode terminal at time intervals while charging the 3-electrode cell from the first SOC to the second SOC; and (e2) obtaining an end voltage of the third voltage profile as the second SOC voltage.

The method of evaluating an electrolyte impregnation level of a secondary battery according to the present disclosure may further comprise: displaying the electrolyte impregnation level through a display; and/or transmitting the electrolyte impregnation level to a computer.

The electrode assembly may include a positive electrode, a negative electrode, and a separator interposed therebetween, which are wound about a winding axis to define a core and an outer circumference, the positive electrode and the negative electrode respectively including an active material portion coated with an active material and an uncoated portion not coated with an active material along a winding direction, the uncoated portion of the positive electrode and the uncoated portion of the negative electrode being exposed to an outside of the separator to oppose each other along the winding axis direction, the uncoated portion of the positive electrode being bent toward the core to form a first bent surface area, the uncoated portion of the negative electrode being bent toward the core to form a second bent surface area.

The case may be a cylindrical can including an open portion at a first side and a bottom portion having a through hole formed therein at a second side opposite to the first side in the winding axis direction. The 3-electrode cell may include a rivet terminal fastened to the through hole so as to be electrically insulated from the cylindrical can, a positive electrode current collection plate configured to connect the first bent surface area and the rivet terminal, and a negative electrode current collection plate configured to connect the second bent surface area and an inner surface of the cylindrical can. The reference electrode may be installed in the core of the electrode assembly or installed between an outer circumference of the electrode assembly and an inner circumference of the case so that one end thereof is exposed to an outside of the electrode assembly, the positive electrode terminal may the rivet terminal, the negative electrode terminal may be the case, and the reference terminal may be a lead connected to the reference electrode.

In another aspect of the present disclosure, there is also provided an apparatus of evaluating an electrolyte impregnation level of a secondary battery, comprising: a mount portion onto which a 3-electrode cell aged for a first time after electrolyte injection is loaded, the 3-electrode cell including a positive electrode terminal, a negative electrode terminal, and a reference terminal; a charging unit configured to apply a charging current to the 3-electrode cell; a voltage measuring unit configured to measure a voltage difference between the reference terminal and the positive electrode terminal; a storage medium configured to store reference voltage information for a plurality of electrolyte impregnation levels; and a control unit operably coupled to the charging unit, the voltage measuring unit, and the storage medium, and the control unit may be configured to: control the charging unit to charge the 3-electrode cell to a first SOC and obtain a first SOC voltage through the voltage measuring unit at the first SOC, stop an operation of the charging unit for a second time and obtain an aging completion voltage through the voltage measuring unit, control the charging unit to charge the 3-electrode cell from the first SOC to a second SOC and obtain a second SOC voltage through the voltage measuring unit at the second SOC, determine at least one of the first SOC voltage, a voltage difference between the first SOC voltage and the aging completion voltage, and a voltage difference between the first SOC voltage and the second SOC voltage as an impregnation evaluation voltage, and identify an electrolyte impregnation level corresponding to the impregnation evaluation voltage from the reference voltage information and determine the identified electrolyte impregnation level as an electrolyte impregnation level of the 3-electrode cell.

The apparatus may further comprise a display operatively coupled with the control unit, and the control unit may be configured to display the electrolyte impregnation level through the display.

The apparatus may further comprise a communication interface operatively coupled with the control unit, and the control unit may be configured to transmit the electrolyte impregnation level to a computer via the communication interface.

In another aspect of the present disclosure, there is also provided a system, comprising: the apparatus of evaluating an electrolyte impregnation level of a secondary battery; and a computer configured to receive the electrolyte impregnation level from the apparatus of evaluating an electrolyte impregnation through a network.

Preferably, the computer may control a process condition applied to an injecting process of the secondary battery by referring to the electrolyte impregnation level.

### Advantageous Effects

According to the present disclosure, the electrolyte impregnation level of an electrode assembly of a secondary battery may be quantitatively and accurately evaluated without disassembling the electrode assembly.

In addition, the electrolyte impregnation level may be optimized to a desired level by monitoring the temporal change in the electrolyte impregnation level using a 3-electrode cell manufactured from a semi-finished cell sampled from a secondary battery production line and adaptively controlling the electrolyte injecting process.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a block diagram showing a schematic configuration of an apparatus 10 of evaluating an electrolyte impregnation level of a secondary battery according to an embodiment of the present disclosure.
FIG. 2 illustrates tables including reference voltage information for a plurality of electrolyte impregnation levels according to types of impregnation evaluation voltage according to an embodiment of the present disclosure.
FIG. 3 is a graph showing voltage profiles measured for a 3-electrode cell (embodiment) with a normal electrolyte impregnation level and a 3-electrode cell (comparative example) with a poor electrolyte impregnation level.
FIG. 4 is a drawing specifically showing a state in which a cylindrical 3-electrode cell is loaded into the apparatus of evaluating an electrolyte impregnation level of a secondary battery according to an embodiment of the present disclosure immediately after electrolyte injection and aging processes.
FIG. 5a is a plan view showing an electrode structure according to an embodiment of the present disclosure.
FIG. 5b is a process diagram showing a winding process of an electrode assembly according to an embodiment of the present disclosure.
FIG. 5c is a perspective view showing an electrode assembly manufactured according to an embodiment of the present disclosure.
FIG. 6 is a flowchart for illustrating a method of evaluating an electrolyte impregnation level of a secondary battery according to an embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Also, to aid understanding of the present disclosure, the attached drawings are not drawn to scale and the dimensions of some components may be exaggerated. In addition, the same reference symbols may be assigned to the same components in different embodiments.

Stating that two objects of comparison are 'the same' means that they are 'substantially the same'. Therefore, the term 'substantially the same' may include a deviation that is considered low in the art, for example, a deviation of less than 10%. Also, uniformity of a parameter in a region may mean that the parameter is uniform from an average perspective in the corresponding region.

Although the terms first, second or the like are used to describe different elements, these elements are not limited by the terms. These terms are used to distinguish one element from another, and unless stated to the contrary, a first element may be a second element.

Throughout the specification, unless stated otherwise, each element may be singular or plural.

When an element is "above (or under)" or "on (or below)" another element, the element can be on an upper surface (or a lower surface) of the other element, and intervening elements may be present between the element and the other element on (or below) the element.

Additionally, when an element is referred to as being "connected", "coupled" or "linked" to another element, the element can be directly connected or coupled to the other element, but it should be understood that intervening elements may be present between each element, or each element may be "connected", "coupled" or "linked" to each other through another element.

Throughout the specification, "A and/or B" refers to either A or B or both A and B unless expressly stated otherwise, and "C to D" refers to C or greater and D or smaller unless expressly stated otherwise.

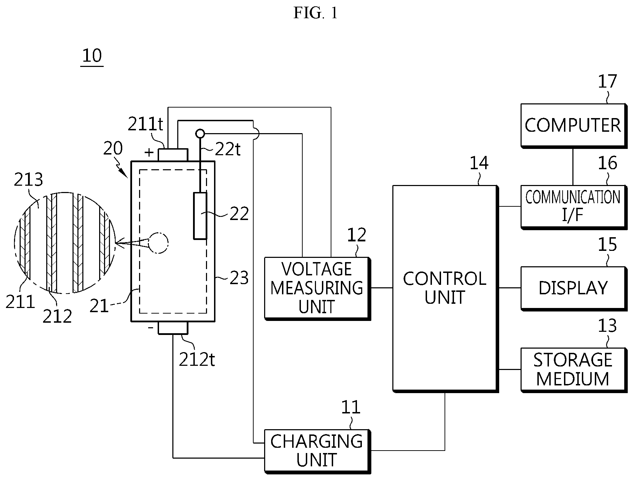

FIG. 1 is a block diagram showing a schematic configuration of an apparatus 10 of evaluating an electrolyte impregnation level of a secondary battery according to an embodiment of the present disclosure.

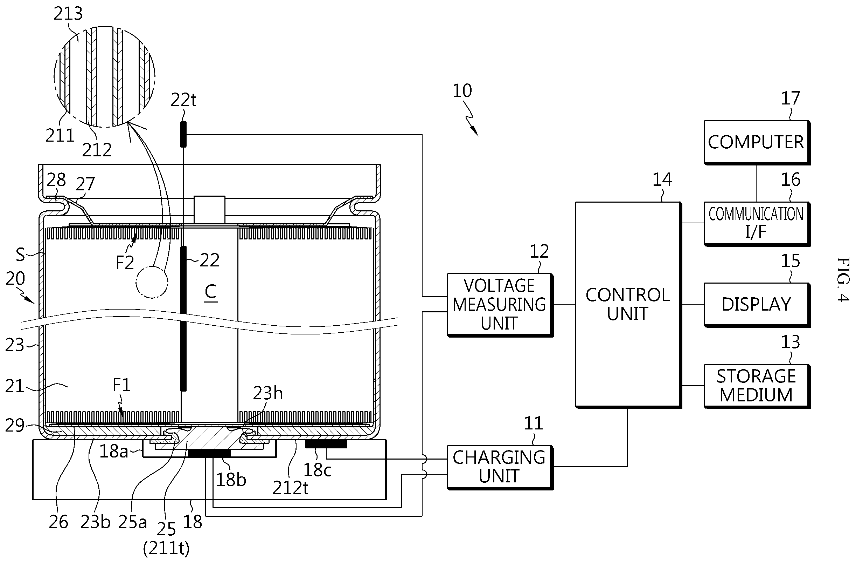

Referring to FIG. 1, the apparatus 10 for evaluating an electrolyte impregnation level of a secondary battery may include a mount portion 18 (FIG. 4) into which a 3-electrode cell 20 to which electrolyte is injected is loaded, a charging unit 11 for applying a charging current to the 3-electrode cell 20, a voltage measuring unit 12 for measuring a voltage difference between a reference terminal 22 and a positive electrode terminal 211t of the 3-electrode cell 20, a storage medium 13 for storing reference voltage information for a plurality of electrolyte impregnation levels in advance, and a control unit 14 operably connected to the charging unit 11, the voltage measuring unit 12, and the storage medium 13.

The 3-electrode cell 20 may include an electrode assembly 21 having a positive electrode 211, a negative electrode 212, and a separator 213 interposed therebetween, a case 23 for accommodating a reference electrode 22 together with the electrode assembly 21, a positive electrode terminal 211t electrically connected to the positive electrode 211, a negative electrode terminal 212t electrically connected to the negative electrode 212, and a reference terminal 22t electrically connected to the reference electrode 22.

There is no special limitation on the structure of the positive electrode terminal 211t as long as it is electrically connected to the positive electrode 211 included in the electrode assembly 21 and exposed to the outside.

There is no special limitation on the structure of the negative electrode terminal 212 as long as it is electrically connected to the negative electrode 212 included in the electrode assembly 21 and exposed to the outside.

In one example, the positive electrode terminal 211t may be a lead terminal of a pouch cell, a rivet terminal installed in a cap or can bottom of a cylindrical cell, a terminal installed in a cap of a rectangular cell, etc. The negative electrode terminal 212t may be a lead terminal of a pouch cell, a can of a cylindrical cell, a terminal installed in a cap of a rectangular cell, etc.

The electrode assembly 21 may have a structure known in the art, such as a stacked structure, a jelly-roll structure, or a stacked/folded structure.

The case 23 is widely used in the art and may be a rectangular can, a cylindrical can or a pouch packaging material.

The reference electrode 22 is an electrode having a potential of 0 volts and may be additionally included in the case 23 to quantitatively evaluate the electrolyte impregnation level. The material of the reference electrode 22 may vary depending on the type of the 3-electrode cell 20. If the 3-electrode cell 20 is a lithium ion cell, the reference electrode 22 may be made of lithium metal.

The reference electrode 22 may be installed at a position separate from the positive electrode 211 and the negative electrode 212 included in the electrode assembly 21 and in contact only with the separator. In one example, if the electrode assembly 21 is an electrode assembly having a jelly-roll structure, the reference electrode 22 may be installed in a core, which is a hollow space at the center of the electrode assembly 21, or may be installed between the outer circumference of the electrode assembly 21 and the inner circumference of the case 23.

There is no particular limitation on the structure of the reference terminal 22t as long as it is electrically connected to the reference electrode 22 installed in case 23 and exposed to the outside. In one example, the reference terminal 22t may be a lead connected to the reference electrode 22.

It is obvious to those skilled in the art that any structure known in the art may be used for the 3-electrode cell.

The 3-electrode cell may be loaded onto the mount portion 18 (FIG. 4) after being aged for a first time after electrolyte injection. The first time may be 0 to 48 hours. In one example, the first time may be 24 hours.

The control unit 14 controls the charging unit 11 to charge the 3-electrode cell 20 to the first SOC (State Of Charge) and obtains the first SOC voltage through the voltage measuring unit 12 at the first SOC. The magnitude of the charging current may be preset. In one example, the magnitude of the charging current may be 0.3C (c-rate). The first SOC voltage is the voltage difference between the reference terminal 22t and the positive electrode terminal 211t.

In one embodiment, the control unit 14 may be configured to control the charging unit 11 to repeatedly obtain a voltage difference between the reference terminal 22t and the positive electrode terminal 211t at time intervals through the voltage measuring unit 12 while charging the 3-electrode cell 20 to a preset first SOC, generate a first voltage profile over time and record the first voltage profile in the storage medium 13, and obtain an end voltage of the first voltage profile as the first SOC voltage.

The first SOC is not particularly limited, but may be set in the range of 3% to 7% of the SOC based on the full charge capacity of the 3-electrode cell 20.

Preferably, the first SOC may be set to a SOC level of 5%, which is the initial SOC of the 3-electrode cell 20.

The control unit 14 also stops the operation of the charging unit 11 for a second time to age the 3-electrode cell 20 and then obtains the aging completion voltage through the voltage measuring unit 12. The aging completion voltage is a voltage difference between the reference terminal 22t and the positive electrode terminal 211t after aging for a second time is completed.

In one embodiment, the control unit 14 may be configured to repeatedly obtain a voltage difference between the reference terminal 22t and the positive electrode terminal 211t through the voltage measuring unit 12 at time intervals while the operation of the charging unit 11 is stopped for a second time, generate a second voltage profile over time and record the second voltage profile in the storage medium 13, and obtain an end voltage of the second voltage profile as the aging completion voltage.

If the operation of the charging unit 11 is stopped, the charging of the 3-electrode cell 20 is stopped, and aging is performed. It is preferable that the temperature of the 3-electrode cell 20 is maintained at room temperature while the 3-electrode cell 20 is being aged. To this end, the mount portion 18 (FIG. 4) may include a fluid circulation mechanism for temperature control and a temperature control mechanism for heating or cooling the fluid.

The second time may be set within the range of 12 hours to 48 hours so that the electrolyte may be sufficiently impregnated into the electrode assembly 21. Preferably, the second time may be 24 hours.

The control unit 14 may also control the charging unit 11 to charge the 3-electrode cell 20 from the first SOC to the second SOC, and obtain the second SOC voltage through the voltage measuring unit 12 at the second SOC. The magnitude of the charging current may be preset. In one example, the magnitude of the charging current may be 0.3C (c-rate). The second SOC voltage is a voltage difference between the reference terminal 22t and the positive electrode terminal 211t after the 3-electrode cell 20 is charged to the second SOC.

In one embodiment, the control unit 14 may be configured to control the charging unit 11 to repeatedly obtain a voltage difference between the reference terminal 22t and the positive electrode terminal 211t at time intervals through the voltage measuring unit 12 while charging the 3-electrode cell 20 from the first SOC to the second SOC, generate a third voltage profile over time and record the third voltage profile in the storage medium 13, and obtain an end voltage of the third voltage profile as the second SOC voltage.

The second SOC is not particularly limited, but may be set to a percentage value greater than the first SOC within a range of SOC 8% to 12% based on the full charge capacity of the 3-electrode cell 20.

Preferably, the second SOC may be set to a level of SOC 10%.

The control unit 14 may also determine at least one of the first SOC voltage, the voltage difference between the first SOC voltage and the aging completion voltage, and the voltage difference between the first SOC voltage and the second SOC voltage as the impregnation evaluation voltage.

The control unit 14 may also identify an electrolyte impregnation level corresponding to the impregnation evaluation voltage from reference voltage information for a plurality of electrolyte impregnation levels recorded in advance in the storage medium 13, and quantitatively determine the identified electrolyte impregnation level as the electrolyte impregnation level of the 3-electrode cell 20.

Preferably, the reference voltage information may include first to n^{th} electrolyte impregnation levels (n is a natural number greater than or equal to 2) and first to n^{th} voltage section information respectively corresponding to the electrolyte impregnation levels.

Preferably, in the reference voltage information, the first to n^{th} voltage section information may be set differently depending on the type of the impregnation evaluation voltage.

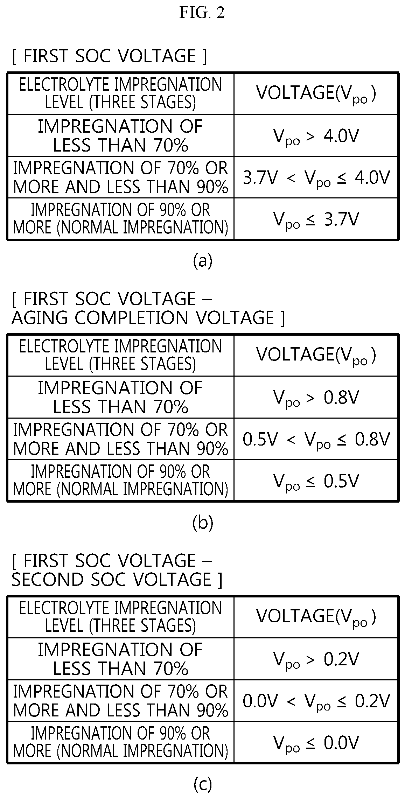

FIG. 2 illustrates tables including reference voltage information for a plurality of electrolyte impregnation levels according to types of impregnation evaluation voltage according to an embodiment of the present disclosure.

The reference voltage information shown in the tables is set based on the case where the 3-electrode cell 20 is a lithium ion cell, the first SOC and the second SOC are 5% and 10%, respectively, and the aging time (second time) after charging of the 3-electrode cell 20 is 24 hours.

The 3-electrode cell 20 includes a lithium transition metal oxide (LiNi_{1/3}Co_{1/3}Mn_{1/3}O₂) as a positive electrode active material, graphite as a negative electrode active material, and an electrolyte including a lithium salt LiPF₆, and DMC (DiMethyl Carbonate) and EC (Ethylene Carbonate) as a solvent.

Referring to (a) of FIG. 2, if the impregnation evaluation voltage (Vₚₒ) is the first SOC voltage, the electrolyte impregnation level may be classified into three stages.

As shown in the figures, the first electrolyte impregnation level is the case where the first SOC voltage exceeds 4.0 V, and the first electrolyte impregnation level is less than 70%. The second electrolyte impregnation level is the case where the first SOC voltage is greater than 3.7 V and less than or equal to 4.0 V, and the second electrolyte impregnation level is greater than or equal to 70% and less than 90%. The third electrolyte impregnation level is the case where the first SOC voltage is less than or equal to 3.7 V, and the third electrolyte impregnation level is greater than or equal to 90%, which is a normal impregnation level.

The electrolyte impregnation level of the 3-electrode cell 20 decreases as the first SOC voltage increases. This is because the lower the electrolyte impregnation level, the smaller the amount of lithium ions moving from the positive electrode to the negative electrode, which increases the first SOC voltage. The voltages of 3.7 V and 4.0 V that divide the boundary of the electrolyte impregnation levels may be determined based on a standard 3-electrode cell whose electrolyte impregnation level is accurately evaluated as 90% or more, 70% or more and less than 90%, and less than 70%, through a disassembling analysis method. The electrolyte impregnation level through the disassembling analysis method may be determined as the area ratio of the electrolyte impregnation region to the total area of the positive electrode. The electrolyte impregnation region and the electrolyte non-impregnation region may be distinguished by examining the color change on the surface of the positive electrode according to the electrolyte impregnation. The voltage that divides the boundary of the electrolyte impregnation levels may change depending on the types of positive electrode active material, negative electrode active material, and electrolyte. The number of electrolyte impregnation levels may be increased further, without being limited to three stages as shown in the figures.

Referring to (b) of FIG. 2, if the impregnation evaluation voltage (Vₚₒ) is the voltage difference between the first SOC voltage and the aging completion voltage, the electrolyte impregnation level may be classified into three stages.

As shown, the first electrolyte impregnation level is the case where the voltage difference between the first SOC voltage and the aging completion voltage exceeds 0.8 V, and the first electrolyte impregnation level is less than 70%. The second electrolyte impregnation level is the case where the voltage difference between the first SOC voltage and the aging completion voltage is greater than 0.5 V and less than or equal to 0.8 V, and the second electrolyte impregnation level is 70% or more and less than 90%. The third electrolyte impregnation level is the case where the voltage difference between the first SOC voltage and the aging completion voltage is less than or equal to 0.5 V, and the third electrolyte impregnation level is 90% or more, which is a normal impregnation level.

As the voltage difference between the first SOC voltage and the aging completion voltage is larger, the electrolyte impregnation level may be quantitatively evaluated to be lower. During aging in the no-load state after the charging of the 3-electrode cell 20 is stopped, lithium ions may move to the electrolyte non-impregnation region of the positive electrode. As the amount of lithium ion movement is greater, the voltage difference between the first SOC voltage and the aging completion voltage increases. Therefore, as the voltage difference is larger, it means that there is more electrolyte non-impregnation region in the positive electrode that induces the movement of lithium ions.

The voltages dividing the boundaries of the electrolyte impregnation levels, which are 0.5 V and 0.8 V, may be determined based on a standard 3-electrode cell, which is accurately evaluated as having electrolyte impregnation levels of 90% or more, 70% or more and less than 90%, and less than 70%, through the disassembling analysis method as described above. The voltage dividing the boundary of the electrolyte impregnation levels may change depending on the types of the positive electrode active material, the negative electrode active material, and the electrolyte. The number of electrolyte impregnation levels is not limited to three stages as illustrated and may be increased further.

Referring to (c) of FIG. 2, if the impregnation evaluation voltage (Vₚₒ) is the voltage difference between the first SOC voltage and the second SOC voltage, the electrolyte impregnation level may be classified into three stages.

As shown, the first electrolyte impregnation level is the case where the voltage difference between the first SOC voltage and the second SOC voltage exceeds 0.2 V, and the first electrolyte impregnation level is less than 70%. The second electrolyte impregnation level is the case where the voltage difference between the first SOC voltage and the second SOC voltage is greater than 0.0 V and less than or equal to 0.2 V, and the second electrolyte impregnation level is 70% or more and less than 90%. The third electrolyte impregnation level is the case where the voltage difference between the first SOC voltage and the second SOC voltage is less than or equal to 0.0 V, and the third electrolyte impregnation level is 90% or more, which is a normal impregnation level.

As the voltage difference between the first SOC voltage and the second SOC voltage is larger, the electrolyte impregnation level may be evaluated to be lower. This is because as the voltage difference between the first SOC voltage and the second SOC voltage is larger, it means that the 3-electrode cell 20 in the initial charge state (SOC 5%) has a low electrolyte impregnation level.

The voltages dividing the boundaries of the electrolyte impregnation levels, which are 0.0 V and 0.2 V, may be determined based on a standard 3-electrode cell in which the electrolyte impregnation level is accurately evaluated as 90% or more, 70% or more and less than 90%, and less than 70% by the disassembling analysis method as described above. The voltage dividing the boundary of the electrolyte impregnation levels may change depending on the types of the positive electrode active material, the negative electrode active material, and the electrolyte. The number of the electrolyte impregnation levels is not limited to three stages as illustrated and may be increased further.

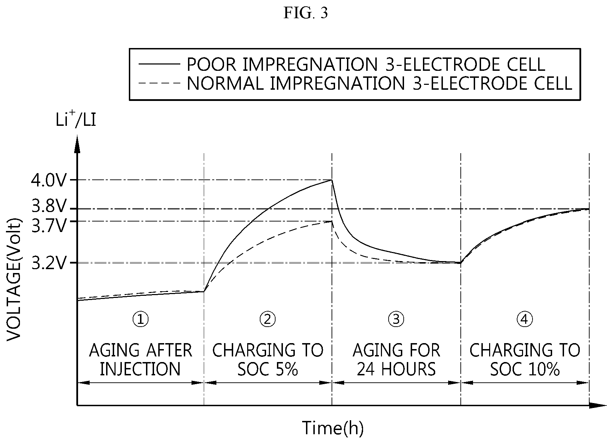

FIG. 3 is a graph showing voltage profiles measured for a 3-electrode cell (embodiment) with a normal electrolyte impregnation level of 90% or higher and a 3-electrode cell (comparative example) with a poor electrolyte impregnation level of 70%.

In FIG. 3, the dotted line graph is a voltage profile for a 3-electrode cell of an embodiment with a normal electrolyte impregnation level, and the solid line graph is a voltage profile for a 3-electrode cell of a comparative example with a poor electrolyte impregnation level.

Also, in FIG. 3, the voltage profile between the reference terminal and the positive electrode terminal measured during aging the 3-electrode cell after injecting electrolyte into the 3-electrode cell is the profile ①. The voltage profile between the reference terminal and the positive electrode terminal measured during charging the 3-electrode cell to SOC 5% (first SOC) at a charging rate of 0.3 C is the profile ②. The voltage profile between the reference terminal and the positive electrode terminal measured during aging the 3-electrode cell at room temperature for 24 hours after stopping charging of the 3-electrode cell is the profile ③. The voltage profile between the reference terminal and the positive electrode terminal measured during charging the 3-electrode cell again from SOC 5% to SOC 10% (second SOC) at a charging rate of 0.3 C is the profile ④.

Referring to FIG. 3, a 3-electrode cell with a normal electrolyte impregnation level has a first SOC voltage of 3.7 V, and a 3-electrode cell with a poor electrolyte impregnation level has a first SOC voltage of 4.0 V.

In addition, the voltage difference between the first SOC voltage and the aging completion voltage of a 3-electrode cell with a normal electrolyte impregnation level is 0.5 V, and the voltage difference between the first SOC voltage and the aging completion voltage of a 3-electrode cell with a poor electrolyte impregnation level is 0.8 V.

In addition, the voltage difference between the first SOC voltage and the second SOC voltage of a 3-electrode cell with a normal electrolyte impregnation level is -0.1 V, and the voltage difference between the first SOC voltage and the second SOC voltage of a 3-electrode cell with a poor electrolyte impregnation level is 0.2 V.

The graph of FIG. 3 supports that the reference voltage information for a plurality of electrolyte impregnation levels defined for each impregnation evaluation voltage according to an embodiment of the present disclosure as shown in FIG. 2 is in good agreement with the actual experiment.

Meanwhile, the reference voltage information for a plurality of electrolyte impregnation levels as shown in FIG. 2 may be stored in advance in the storage medium 13 as a look-up table.

In another embodiment, the control unit 14 may quantitatively determine a plurality of electrolyte impregnation levels by comparing each of the plurality of impregnation evaluation voltages obtained for the 3-electrode cell 20 with the corresponding reference voltage information, and determine an average of the plurality of electrolyte impregnation levels as the electrolyte impregnation level of the 3-electrode cell.

Specifically, the control unit 14 may determine the first SOC voltage, the voltage difference between the first SOC voltage and the aging completion voltage, and the voltage difference between the first SOC voltage and the second SOC voltage as a first impregnation evaluation voltage, a second impregnation evaluation voltage, and a third impregnation evaluation voltage, respectively.

The control unit 14 may also quantitatively determine a first electrolyte impregnation level corresponding to the first impregnation evaluation voltage from first reference voltage information (e.g., a table in (a) of FIG. 2) for a plurality of electrolyte impregnation levels, quantitatively determine a second electrolyte impregnation level corresponding to the second impregnation evaluation voltage from second reference voltage information (e.g., a table in (b) of FIG. 2) for a plurality of electrolyte impregnation levels, quantitatively determine a third electrolyte impregnation level corresponding to the third impregnation evaluation voltage from third reference voltage information (e.g., a table in (c) of FIG. 2) for a plurality of electrolyte impregnation levels, and determine an average of the first electrolyte impregnation level, the second electrolyte impregnation level, and the third electrolyte impregnation level as the electrolyte impregnation level of the 3-electrode cell.

If the average of the plurality of electrolyte impregnation levels determined from the plurality of impregnation evaluation voltages is determined as the electrolyte impregnation level of the 3-electrode cell in this way, the reliability of the impregnation evaluation results may be improved.

Referring to FIG. 1 again, the apparatus 10 of evaluating an electrolyte impregnation level of a secondary battery according to an embodiment of the present disclosure may further include a display 15 and/or a communication interface 16.

The control unit 14 may be operably coupled with the display 15 and/or the communication interface 16.

The control unit 14 may also be configured to visually display the electrolyte impregnation level for the 3-electrode cell through the display 15. Preferably, the electrolyte impregnation level may be quantitatively displayed as a number or graph.

The control unit 14 may also be configured to transmit the electrolyte impregnation level for the 3-electrode cell to the computer 17 through the communication interface 16. The computer 17 may be a server that manages the production process of the secondary battery. The server may adjust process variables applied to the electrolyte injecting process of the secondary battery to increase the electrolyte impregnation level to a required level if the electrolyte impregnation level for the 3-electrode cell is lower than a reference level. In one example, the server may adjust the electrolyte injection amount and/or the electrolyte injection pressure and/or the electrolyte temperature and/or the internal pressure of the electrolyte injection facility.

In the above embodiment, the 3-electrode cell may be manufactured from a semi-finished product of a secondary battery cell that is randomly sampled from a production line of the secondary battery. In addition, the computer 17 may be connected to the apparatus 10 of evaluating an electrolyte impregnation level of a secondary battery through a network.

By doing so, the electrolyte impregnation level may be optimized to a desired level by monitoring the temporal change in the electrolyte impregnation level using a 3-electrode cell manufactured from a semi-finished cell sampled from a secondary battery production line and adaptively controlling the electrolyte injecting process.

FIG. 4 is a drawing specifically showing a state in which a 3-electrode cell manufactured in a cylindrical cell structure is loaded into the apparatus of evaluating an electrolyte impregnation level of a secondary battery according to an embodiment of the present disclosure immediately after an electrolyte injection and aging processes.

Referring to FIG. 4, the 3-electrode cell 20 may have a structure of a cylindrical cell including an electrode assembly 21 having a jelly-roll structure.

The electrode assembly 21 has a jelly-roll structure in which a positive electrode, a negative electrode, and a separator interposed therebetween are wound around a winding axis, thereby defining a core C and an outer circumference S. The core C may be an empty space at the center of the electrode assembly 21. A winding core member (not shown) used in the winding process may be inserted into the core C.

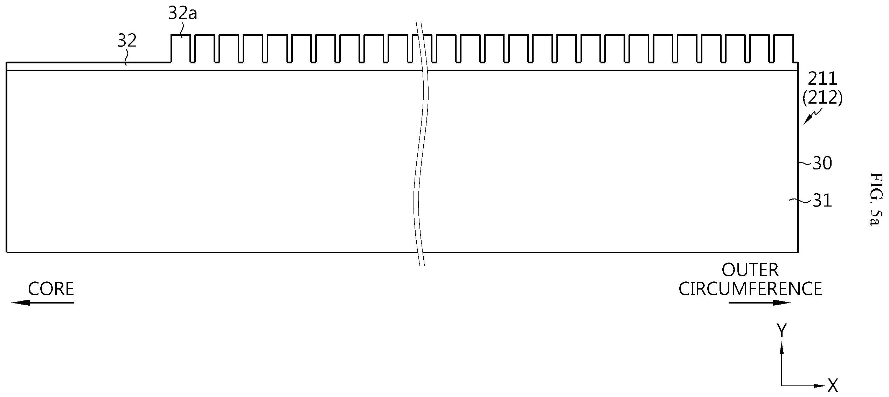

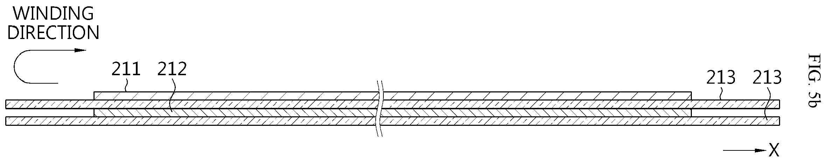

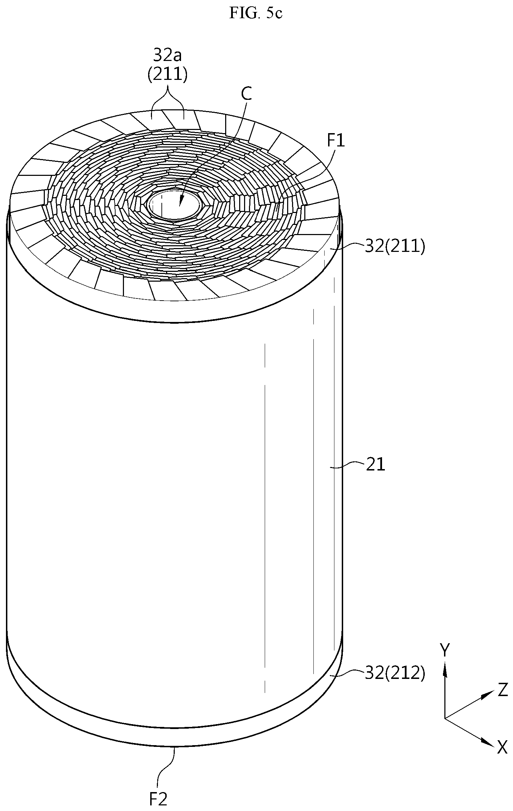

FIGS. 5a to 5c are drawings for illustrating a manufacturing process for an electrode assembly 21 having a jelly-roll structure included in the 3-electrode cell 20 according to an embodiment of the present disclosure. FIG. 5a shows the structure of an electrode, FIG. 5b shows a winding process of an electrode, and FIG. 5c is a perspective view showing the manufactured electrode assembly 21.

Referring to FIGS. 5A to 5C, the positive electrode 211 and the negative electrode 212 have a structure in which an active material 31 is coated on a sheet-shaped current collector 30, and include an uncoated portion 32 at one long side along the winding direction X. The uncoated portion 32 may be divided into a plurality of segments 32a. A notching groove or a cutting line may be formed between the segments 32a. The shape of the segment 32a may be a rectangle, a trapezoid, or a parallelogram. The region of the uncoated portion 32 adjacent to the core may have a relatively low height. Optionally, the region of the uncoated portion 32 adjacent to the outer circumference may also have a relatively low height.

The electrode assembly 21 is manufactured by sequentially stacking the positive electrode 211 and the negative electrode 212 together with two separators 213 as shown in FIG. 5b and then winding them in a one direction X. At this time, the uncoated portions of the positive electrode 211 and the negative electrode 212 are arranged in opposite directions in the winding axis direction, and when the winding of the electrode assembly 21 is completed, they are exposed to the outside of the separator 213 along the winding axis direction. The negative electrode 212 is longer than the positive electrode 211. In addition, the entire region of the positive electrode 211 overlaps with the negative electrode 212 in the longitudinal direction.

After the electrode assembly 21 is wound, the segments 32a included in the uncoated portion 32 of the positive electrode 211 are bent in the direction toward the core C as shown in FIG. 5c to form a first bent surface area F1 at the upper portion of the electrode assembly 21. Similarly, the segments 32a (not shown) included in the uncoated portion 32 of the negative electrode 212 are also bent in the direction toward the core C to form a second bent surface area F2 at the lower portion of the electrode assembly 21.

Referring to FIG. 4 again, the case 23 is a cylindrical can having an upper first side that is open, and a lower second side opposite to the first side, that may have a bottom portion 23b in which a through hole 23h is formed.

The 3-electrode cell 20 may also include a rivet terminal 25 installed in the through hole 23h with a gasket 25a interposed therebetween so as to be electrically insulated from the case 23. An insulator 29 may be interposed between the inner surface of the bottom portion 23b of the case 23 and the first bent surface area F1. Also, the electrode assembly 21 may be inserted into the case 23 such that the first bent surface area F1 faces the bottom portion 23b of the case 23.

The 3-electrode cell 20 may also include a positive electrode current collection plate 26 for electrically connecting the first bent surface area F1 and the rivet terminal 25, and a negative electrode current collection plate 27 for electrically connecting the second bent surface area F2 and the inner surface of the case 23.

The flat portion of the rivet terminal 25 facing the positive electrode current collection plate 26 may be welded to the positive electrode current collection plate 26 through the insulator 29. Also, at least a part (e.g., an edge) of the negative electrode current collection plate 27 may be in contact with the inner surface of the beading portion 28 formed near the open portion of the case 23. Of course, the negative electrode current collection plate 27 may also be in contact with the flat inner surface of the case 23.

In the 3-electrode cell 20, the reference electrode 22 may be attached to the inner circumference of the core C by an adhesive member so that one end may be exposed to the outside of the electrode assembly 21. Alternatively, the reference electrode 22 may be installed between the outer circumference S of the electrode assembly 21 and the inner circumference of the case 23.

The electrolyte may be injected through the open portion at the upper portion of the case 23. The 3-electrode cell 20 is manufactured for the purpose of quantitatively evaluating the electrolyte impregnation level. Therefore, after the electrolyte is injected into the case 23, the open portion of the case 23 may not be sealed for easy connection of the reference electrode 22 and a voltage measuring probe.

Alternatively, the open portion of the case 23 may be sealed by a cap assembly (not shown) after electrolyte injection. When sealing the open portion of the case 23, a sealing gasket (not shown) may be interposed between the top end of the case 23 and the cap assembly (not shown), and the top of the case 23 may be crimped to integrally fix the sealing gasket and the cap assembly to the top end of the case 23.

The structure of the cell including the rivet terminal 25 shown in FIG. 4 is disclosed in detail in Korean patent registration No. 10-2446797. Accordingly, the cell structure disclosed in the registered patent may be equally applied to the 3-electrode cell 20 of the present disclosure.

The 3-electrode cell 20 may be mounted on the mount portion 18. The mount portion 18 may include a groove 18a that receives an externally exposed portion of the rivet terminal 25, a positive electrode probe 18b that contacts the lower surface of the rivet terminal 25 corresponding to a positive electrode terminal, and a negative electrode probe 18c that contacts the lower surface of the case 23 functioning as a negative electrode terminal around the rivet terminal 25.

The voltage measurement lines may be formed between the voltage measuring unit 12 and the mount portion 18. Also, a voltage measurement line may be formed between the voltage measuring unit 12 and the reference terminal 22t connected to the reference electrode 22.

In the present disclosure, the charging unit 11 may apply a charging power through the positive electrode probe 18b and the negative electrode probe 18c of the mount portion 18. The charging unit 11 may support various charging protocols such as constant current-constant voltage charging, step charging, pulse charging and so on. Since the H/W configuration and operation mechanism of the charging unit 11 are widely known in the art, and thus will not be described in detail.

The charging unit 11 may determine the change amount of SOC through the ampere counting method and charge the 3-electrode cell 20 up to a desired SOC according to the request of the control unit 14.

The voltage measuring unit 12 may include a voltage measuring circuit capable of measuring a voltage difference between the reference terminal 22t and the positive electrode terminal 211t. Since the voltage measuring circuit is widely known in the art, and thus will not be described in detail.

There is no particular limitation on the type of the storage medium 13 as long as it may record and erase data and/or information. As an example, the storage medium 13 may be RAM, ROM, a register, a flash memory, a hard disk, or a magnetic recording medium.

The storage medium 13 may be electrically connected to the control unit 14, for example via a data bus, so as to be accessed by the control unit 14.

The storage medium 13 stores and/or updates and/or erases and/or transmits programs including various control logics performed by the control unit 14, and/or data generated when the control logic is executed, and/or preset data or look-up information/tables, etc.

The control unit 14 may optionally include a processor, an application-specific integrated circuit (ASIC), other chipsets, logic circuits, registers, communication modems, data processing devices, etc. known in the art to execute the various control logics described above. Also, when the control logics are implemented as software, the control unit 14 may be implemented a set of program modules. At this time, the program module may be stored in a memory and executed by the processor. The memory may be provided inside or outside the processor, and may be connected to the processor by various well-known computer components. Also, the memory may be included in the storage medium 13 of the present disclosure. Also, the memory generically refers to a device that stores information regardless of the type of device, and does not refer to a specific memory device.

In addition, one or more of the various control logics of the control unit 14 are combined, and the combined control logics may be written in a computer-readable code system and recorded on a computer-readable storage medium. The type of the storage medium is not particularly limited as long as it can be accessed by a processor included in a computer. As an example, the storage medium includes at least one selected from the group including a ROM, a RAM, a register, a CD-ROM, a magnetic tape, a hard disk, a floppy disk, and an optical data recording device. In addition, the code system may be distributed and stored and executed in computers connected through a network. In addition, functional programs, codes and code segments for implementing the combined control logics may be easily inferred by programmers in the art to which the present disclosure belongs.

The apparatus 10 of evaluating an electrolyte impregnation level of a secondary battery and the computer 17 according to the present disclosure may constitute a system for managing the injecting process of a secondary battery production line.

Hereinafter, a method of evaluating an electrolyte impregnation level of a secondary battery is described in detail.

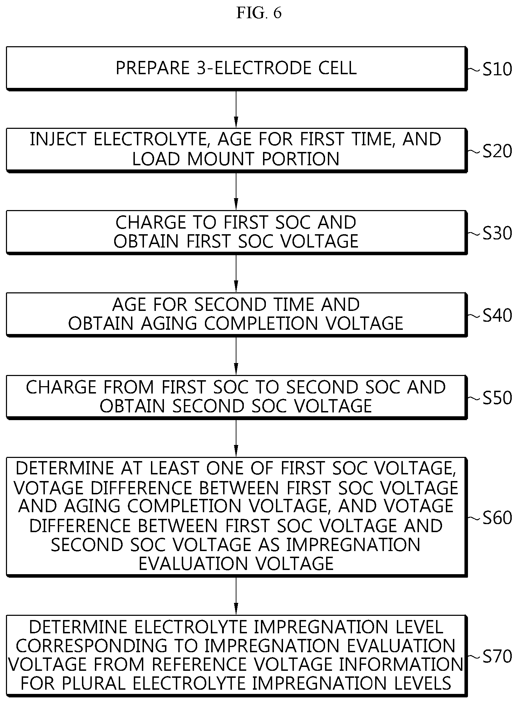

FIG. 6 is a flowchart for illustrating a method of evaluating an electrolyte impregnation level of a secondary battery according to an embodiment of the present disclosure.

Referring to FIG. 6 together with FIG. 1, first, in Step S10, a 3-electrode cell 20 is prepared. The 3-electrode cell 20 may be manufactured by randomly sampling a semi-finished cell before the sealing process is performed in the production line of a secondary battery.

Next, in Step S20, electrolyte is injected into the 3-electrode cell 20, the 3-electrode cell 20 is aged for the first time (e.g., 24 hours), and the 3-electrode cell 20 is loaded into the mount portion 18 (FIG. 4).

Next, in Step S30, the control unit 14 controls the charging unit 11 to charge the 3-electrode cell 20 to the first SOC (e.g., SOC 5%), and obtains the first SOC voltage corresponding to the voltage difference between the reference terminal 22t and the positive electrode terminal 211t through the voltage measuring unit 12.

In one embodiment, in Step S30, the control unit 14 controls the charging unit 11 to repeatedly measure a voltage difference between the reference terminal 22t and the positive electrode terminal 211t at time intervals while charging the 3-electrode cell 20 to the first SOC, generate a first voltage profile over time and record the first voltage profile in the storage medium 13, and obtain an end voltage of the first voltage profile as the first SOC voltage.

Next, in Step S40, the control unit 14 stops the operation of the charging unit 11 for a second time (e.g., 24 hours) to age the 3-electrode cell 20 at room temperature for the second time, and obtains the aging completion voltage corresponding to the voltage difference between the reference terminal 22t and the positive electrode terminal 211t after the aging is completed.

In one embodiment, in Step S40, the control unit 14 repeatedly measures a voltage difference between the reference terminal 22t and the positive electrode terminal 211t at time intervals while aging the 3-electrode cell 20 in a no-load state for the second time, generates a second voltage profile over time and records the second voltage profile in the storage medium 13, and obtains an end voltage of the second voltage profile as the aging completion voltage.

Subsequently, in Step S50, the control unit 14 controls the charging unit 11 to charge the 3-electrode cell 20 from the first SOC (e.g., SOC 5%) to the second SOC (e.g., SOC 10%), and obtains the second SOC voltage corresponding to the voltage difference between the reference terminal 22t and the positive electrode terminal 211t through the voltage measuring unit 12.

In one embodiment, in Step S50, the control unit 14 controls the charging unit 11 to repeatedly measure a voltage difference between the reference terminal 22t and the positive electrode terminal 211t at time intervals while charging the 3-electrode cell 20 from the first SOC to the second SOC, generate a third voltage profile over time and record the third voltage profile in the storage medium 13, and obtain an end voltage of the third voltage profile as the second SOC voltage.

Subsequently, in Step S60, the control unit 14 determines at least one of the first SOC voltage, the voltage difference between the first SOC voltage and the aging completion voltage, and the voltage difference between the first SOC voltage and the second SOC voltage as an impregnation evaluation voltage.

Subsequently, in Step S70, the control unit 14 identifies an electrolyte impregnation level corresponding to the impregnation evaluation voltage from reference voltage information for a plurality of predefined electrolyte impregnation levels, and quantitatively determines the identified electrolyte impregnation level as the electrolyte impregnation level of the 3-electrode cell.

Preferably, the reference voltage information may include first to n^{th} electrolyte impregnation levels (n is a natural number greater than or equal to 2) and first to n^{th} voltage section information respectively corresponding to the electrolyte impregnation levels.

Preferably, in the reference voltage information, the first to n^{th} voltage section information may be set differently depending on the type of the impregnation evaluation voltage (see FIG. 2).

According to another embodiment, in Step S60, the control unit 14 may determine the first SOC voltage, the voltage difference between the first SOC voltage and the aging completion voltage, and the voltage difference between the first SOC voltage and the second SOC voltage as the first impregnation evaluation voltage, the second impregnation evaluation voltage, and the third impregnation evaluation voltage, respectively.

In addition, in Step S70, the control unit 14 may quantitatively determine the first electrolyte impregnation level, the second electrolyte impregnation level and the third electrolyte impregnation level corresponding to the first impregnation evaluation voltage, the second impregnation evaluation voltage and the third impregnation evaluation information, respectively, from reference voltage information for a plurality of electrolyte impregnation levels predefined for each type of impregnation evaluation voltage, and determine an average of the first electrolyte impregnation level, the second electrolyte impregnation level and the third electrolyte impregnation level as the electrolyte impregnation level of the 3-electrode cell.

The method of using a plurality of impregnation evaluation voltages as above may further improve the reliability of the electrolyte impregnation evaluation results.

An embodiment of the present disclosure may further include a step in which the control unit 14 outputs an electrolyte impregnation level for the 3-electrode cell 20 through a display 15; and/or a step in which the control unit 14 transmits the electrolyte impregnation level for the 3-electrode cell 20 to a computer 17 through a communication interface 16. The computer 17 may be a server that manages a production line of a secondary battery. As described above, the server may adaptively adjust and optimize process variables of an electrolyte injecting process by referring to the electrolyte impregnation level received from the control unit 14.

In describing various embodiments of the present disclosure, elements named '... unit' should be understood as functionally distinct elements rather than physically distinct elements. Thus, each component may be selectively integrated with other components or each component may be divided into sub-components for efficient execution of control logics. However, it is obvious to those skilled in the art that even if the components are integrated or divided, if the same function can be recognized, the integrated or divided components should also be interpreted as falling within the scope of the present disclosure.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

## Claims

1. A method of evaluating an electrolyte impregnation level of a secondary battery, comprising:
(a) preparing a 3-electrode cell including a positive electrode terminal, a negative electrode terminal, and a reference terminal;
(b) injecting electrolyte into a case of the 3-electrode cell and aging the 3-electrode cell for a first time;
(c) charging the 3-electrode cell to a preset first State Of Charge (SOC) and obtaining a first SOC voltage between the reference terminal and the positive electrode terminal at the first SOC;
(d) aging the 3-electrode cell in a no-load state for a second time and then obtaining an aging completion voltage between the reference terminal and the positive electrode terminal;
(e) obtaining a second SOC voltage between the reference terminal and the positive electrode terminal at a second SOC while charging the 3-electrode cell from the first SOC to the second SOC;
(f) determining at least one of the first SOC voltage, a voltage difference between the first SOC voltage and the aging completion voltage, and a voltage difference between the first SOC voltage and the second SOC voltage as an impregnation evaluation voltage; and
(g) identifying an electrolyte impregnation level corresponding to the impregnation evaluation voltage from reference voltage information for a plurality of predefined electrolyte impregnation levels and determining the identified electrolyte impregnation level as an electrolyte impregnation level of the 3-electrode cell.

2. The method of evaluating an electrolyte impregnation level of a secondary battery according to claim 1,
wherein the reference voltage information includes first to n^{th} electrolyte impregnation levels (n is a natural number greater than or equal to 2) and first to n^{th} voltage section information respectively corresponding to the electrolyte impregnation levels.

3. The method of evaluating an electrolyte impregnation level of a secondary battery according to claim 2,
wherein, in the reference voltage information, the first to n^{th} voltage section information are set differently depending on a type of the impregnation evaluation voltage.

4. The method of evaluating an electrolyte impregnation level of a secondary battery according to claim 1,
wherein in (f) step, the first SOC voltage, the voltage difference between the first SOC voltage and the aging completion voltage, and the voltage difference between the first SOC voltage and the second SOC voltage are determined as a first impregnation evaluation voltage, a second impregnation evaluation voltage, and a third impregnation evaluation voltage, respectively, and
wherein in the (g) step, a first electrolyte impregnation level, a second electrolyte impregnation level, and a third electrolyte impregnation level respectively corresponding to the first impregnation evaluation voltage, the second impregnation evaluation voltage, and the third impregnation evaluation information are determined from the reference voltage information for the plurality of predefined electrolyte impregnation levels, and an average of the first electrolyte impregnation level, the second electrolyte impregnation level, and the third electrolyte impregnation level is determined as the electrolyte impregnation level of the 3-electrode cell.

5. The method of evaluating an electrolyte impregnation level of a secondary battery according to claim 1,
wherein the first time is 0 to 48 hours, and the second time is 12 to 48 hours.

6. The method of evaluating an electrolyte impregnation level of a secondary battery according to claim 1,
wherein the first SOC is 3% to 7%, and the second SOC is 8% to 12%.

7. The method of evaluating an electrolyte impregnation level of a secondary battery according to claim 1, wherein the (c) step includes:
(c1) generating a first voltage profile by repeatedly measuring a voltage difference between the reference terminal and the positive electrode terminal at time intervals while charging the 3-electrode cell to a preset first SOC; and
(c2) obtaining an end voltage of the first voltage profile as the first SOC voltage.

8. The method of evaluating an electrolyte impregnation level of a secondary battery according to claim 1, wherein the (d) step includes:
(d1) generating a second voltage profile by repeatedly measuring a voltage difference between the reference terminal and the positive electrode terminal at time intervals while aging the 3-electrode cell in a no-load state for a second time; and
(d2) obtaining an end voltage of the second voltage profile as the aging completion voltage.

9. The method of evaluating an electrolyte impregnation level of a secondary battery according to claim 1, wherein the (e) step includes:
(e1) obtaining a third voltage profile by repeatedly measuring a voltage difference between the reference terminal and the positive electrode terminal at time intervals while charging the 3-electrode cell from the first SOC to the second SOC; and
(e2) obtaining an end voltage of the third voltage profile as the second SOC voltage.

10. The method of evaluating an electrolyte impregnation level of a secondary battery according to claim 1, further comprising:
displaying the electrolyte impregnation level through a display.

11. The method of evaluating an electrolyte impregnation level of a secondary battery according to claim 1, further comprising:
transmitting the electrolyte impregnation level to a computer.

12. The method of evaluating an electrolyte impregnation level of a secondary battery according to claim 1,
wherein an electrode assembly includes a positive electrode, a negative electrode, and a separator interposed therebetween, which are wound about a winding axis to define a core and an outer circumference, the positive electrode and the negative electrode respectively including an active material portion coated with an active material and an uncoated portion not coated with an active material along a winding direction, the uncoated portion of the positive electrode and the uncoated portion of the negative electrode being exposed to an outside of the separator to oppose each other along a winding axis direction, the uncoated portion of the positive electrode being bent toward the core to form a first bent surface area, and the uncoated portion of the negative electrode being bent toward the core to form a second bent surface area,
wherein the case is a cylindrical can including an open portion at a first side and a bottom portion having a through hole formed therein at a second side opposite to the first side in the winding axis direction,
wherein the 3-electrode cell includes a rivet terminal fastened to the through hole so as to be electrically insulated from the cylindrical can, a positive electrode current collection plate configured to connect the first bent surface area and the rivet terminal, and a negative electrode current collection plate configured to connect the second bent surface area and an inner surface of the cylindrical can,
wherein the reference electrode is installed in the core of the electrode assembly or installed between the outer circumference of the electrode assembly and an inner circumference of the case so that one end thereof is exposed to an outside of the electrode assembly, and
wherein the positive electrode terminal is the rivet terminal, the negative electrode terminal is the case, and the reference terminal is a lead connected to the reference electrode.

13. An apparatus of evaluating an electrolyte impregnation level of a secondary battery, comprising:
a mount portion onto which a 3-electrode cell aged for a first time after electrolyte injection is loaded, the 3-electrode cell including a positive electrode terminal, a negative electrode terminal, and a reference terminal;
a charging unit configured to apply a charging current to the 3-electrode cell;
a voltage measuring unit configured to measure a voltage difference between the reference terminal and the positive electrode terminal;
a storage medium configured to store reference voltage information for a plurality of electrolyte impregnation levels; and
a control unit operably coupled to the charging unit, the voltage measuring unit, and the storage medium,
wherein the control unit is configured to:
control the charging unit to charge the 3-electrode cell to a first State Of Charge (SOC) and obtain a first SOC voltage through the voltage measuring unit at the first SOC,
stop an operation of the charging unit for a second time and obtain an aging completion voltage through the voltage measuring unit,
control the charging unit to charge the 3-electrode cell from the first SOC to a second SOC and obtain a second SOC voltage through the voltage measuring unit at the second SOC,
determine at least one of the first SOC voltage, a voltage difference between the first SOC voltage and the aging completion voltage, and a voltage difference between the first SOC voltage and the second SOC voltage as an impregnation evaluation voltage, and
identify an electrolyte impregnation level corresponding to the impregnation evaluation voltage from the reference voltage information and determine the identified electrolyte impregnation level as an electrolyte impregnation level of the 3-electrode cell.

14. The apparatus of evaluating an electrolyte impregnation level of a secondary battery according to claim 13,
wherein the reference voltage information includes first to n^{th} electrolyte impregnation levels (n is a natural number greater than or equal to 2) and first to n^{th} voltage section information respectively corresponding to the electrolyte impregnation levels.

15. The apparatus of evaluating an electrolyte impregnation level of a secondary battery according to claim 14,
wherein the reference voltage information is set differently depending on a type of the impregnation evaluation voltage.

16. The apparatus of evaluating an electrolyte impregnation level of a secondary battery according to claim 13,
wherein the control unit is configured to control the charging unit to repeatedly obtain a voltage difference between the reference terminal and the positive electrode terminal through the voltage measuring unit at time intervals while charging the 3-electrode cell to the preset first SOC, generate a first voltage profile over time and record the first voltage profile in the storage medium, and obtain an end voltage of the first voltage profile as the first SOC voltage.

17. The apparatus of evaluating an electrolyte impregnation level of a secondary battery according to claim 13,
wherein the control unit is configured to repeatedly obtain a voltage difference between the reference terminal and the positive electrode terminal at time intervals through the voltage measuring unit while an operation of the charging unit is stopped for a second time, generate a second voltage profile over time and record the second voltage profile in the storage medium, and obtain an end voltage of the second voltage profile as the aging completion voltage.

18. The apparatus of evaluating an electrolyte impregnation level of a secondary battery according to claim 13,
wherein the control unit is configured to control the charging unit to repeatedly obtain a voltage difference between the reference terminal and the positive electrode terminal at time intervals through the voltage measuring unit while charging the 3-electrode cell from the first SOC to the second SOC, generate a third voltage profile over time and record the third voltage profile in the storage medium, and obtain an end voltage of the third voltage profile as the second SOC voltage.

19. The apparatus of evaluating an electrolyte impregnation level of a secondary battery according to claim 13, further comprising:
a display operatively coupled with the control unit,
wherein the control unit is configured to display the electrolyte impregnation level through the display.

20. The apparatus of evaluating an electrolyte impregnation level of a secondary battery according to claim 13, further comprising:
a communication interface operatively coupled with the control unit,
wherein the control unit is configured to transmit the electrolyte impregnation level to a computer via the communication interface.

21. A system, comprising:
the apparatus of evaluating an electrolyte impregnation level of a secondary battery according to claim 13; and
a computer configured to receive the electrolyte impregnation level from the apparatus of evaluating an electrolyte impregnation through a network,
wherein the computer controls a process condition applied to an injecting process of the secondary battery by referring to the electrolyte impregnation level.
